# NEW EUROPEAN PATENT SPECIFICATION

(11) **EP 3 374 537 B2**
(45) Date of publication and mention of the opposition decision: **23.10.2024**
(45) Mention of the grant of the patent: 06.04.2022
(21) Application number: 16785435.5
(22) Date of filing: 20.10.2016
(51) Int. Cl.: C23C 14/48, C23C 14/02

(54) **A METHOD FOR PRE-TREATING A SURFACE FOR COATING**
VERFAHREN ZUM VORBEHANDELN EINER OBERFLÄCHE ZUM BESCHICHTEN
PROCÉDÉ DE PRÉTRAITEMENT D'UNE SURFACE DE REVÊTEMENT

(30) Priority: 10.11.2015 WO PCT/EP2015/193876
(43) Date of publication of application: 19.09.2018
(73) Proprietor: Sandvik Intellectual Property AB, 811 81 Sandviken (SE)
(72) Inventor: CARLSTRÖM, Carl-Fredrik, 123 43 Farsta (SE); AHLGREN, Mats, SE-187 64 Täby (SE); EHIASARIAN, Arutiun, Papken, Sheffield S11 9RB (GB); HOVSEPIAN, Papken, Ehiasar, Sheffield S2 5LZ (GB)
(74) Representative: Sandvik
(86) International application number: PCT/EP2016/075171
(87) International publication number: WO 2017/080774

(56) References cited:
- US-A- 5 061 512
- US-A1- 2011 180 389
- MUNZ W-D, ET AL: "Industrial applications of HIPIMS", JOURNAL OF PHYSICS: CONFERENCE SERIES, INSTITUTE OF PHYSICS PUBLISHING, BRISTOL, GB, vol. 100, no. Part. 8, 1 March 2008 (2008-03-01), GB , pages 1 - 6, ISSN: 1742-6596, DOI: 10.1088/1742-6596/100/8/082001
- GUDMUNDSSON J. T.; BRENNING N.; LUNDIN D.; HELMERSSON U.: "High power impulse magnetron sputtering discharge", JOURNAL OF VACUUM SCIENCE, AMERICAN INSTITUTE OF PHYSICS, 2 HUNTINGTON QUADRANGLE, MELVILLE, NY 11747, vol. 30, no. 3, 1 May 2012 (2012-05-01), 2 Huntington Quadrangle, Melville, NY 11747, pages 30801 - 030801-35, ISSN: 0734-2101, DOI: 10.1116/1.3691832
- E. BROITMAN ET AL: "Industrial-scale deposition of highly adherent CNx films on steel substrates", SURFACE AND COATINGS TECHNOLOGY, vol. 204, no. 21-22, 31 March 2010 (2010-03-31), pages 3349 - 3357, XP055038818, ISSN: 0257-8972, DOI: 10.1016/j.surfcoat.2010.03.038
- ZENG Z M ET AL: "Ion enhanced deposition by dual titanium and acetylene plasma immersion ion implantation", JOURNAL OF VACUUM SCIENCE AND TECHNOLOGY: PART A, AVS /AIP, MELVILLE, NY., US, vol. 21, no. 1, 10 December 2002 (2002-12-10), pages 175 - 179, XP012006265, ISSN: 0734-2101, DOI: 10.1116/1.1531136
- ANDERS ET AL: "Plasma and ion sources in large area coating: A review", SURFACE AND COATINGS TECHNOLOGY, ELSEVIER, AMSTERDAM, NL, vol. 200, no. 5-6, 21 November 2005 (2005-11-21), pages 1893 - 1906, XP005173240, ISSN: 0257-8972, DOI: 10.1016/J.SURFCOAT.2005.08.018

## Description

### Technical field

The present disclosure relates to a method for producing a coated substrate being a cutting tool comprising pre-treating a substrate for a surface coating.

### Background art

Physical vapor deposition (PVD) is a method for applying coatings onto workpieces, for example to increase wear resistance of the workpiece. The surface of the workpiece is often etched in the PVD-apparatus to ensure good adhesion of the coating. Etching may be performed by producing a plasma of argon ions in the PVD apparatus and applying an electrical potential on the substrate to accelerate the argon ions towards the substrate in order to remove organic dirt and native oxides, or other impurities therefrom. The adhesion of the coating may also be improved by introducing metal ions into the surface of the workpiece, so called implantation. Implantation of metal ions is typically achieved by performing the argon etching in the presence of a metal target such that both argon ions and metal ions are produced in the plasma.

EP126003B1 describes a method in which a substrate is pretreated by chromium-ions in an argon atmosphere in a PVD apparatus operating in HIPIMS-mode. The PVD-apparatus is operated such that that the substrate is simultaneous etched and subjected to metal ion implantation.

DE10 2008 021 912 describes an arrangement for magnetic sputtering of substrates. The arrangement is operated in HIPIMS-mode to produce metal ions in an argon atmosphere in order to etch the surface of the substrate and to introduce metal ions into the surface of the substrate to improve adhesion of a subsequently deposited coating. The arrangement comprises two HIPIMS-power sources which are synchronized in order to optimize the electrical potential of the substrate with regards to the ion density in the atmosphere during pretreatment of the substrate.

US2011/180389 A1 and US5061512 A are also representing pertinent prior art documents.

A drawback with the known pretreatment methods is that they may cause preferential etching of edges of the substrate. That is, a high concentration of argon- and metal ions will be drawn to the edges of the substrate and cause wear and excessive heating thereof. Preferential etching is particularly a problem in pretreatment of cutting tools, since preferential etching may cause the edges to lose much of their original geometry and thus reduce performance of the tool.

A further drawback with known pretreatment methods is that simultaneous etching and ion implantation results in long pretreatment times and as a consequence thereof excessive heating of the substrate. Excessive heating of the substrate may result in deterioration of important material properties of the substrate, for example causing brittleness in hard metal.

Thus, it is an object of the present disclosure to achieve an improved method for pretreating a surface which solves or at least mitigates one or more of the above mentioned problems. Moreover, it is an object of the present disclosure to achieve a method for pretreatment of a substrate in which the substrate is subjected to etching and ion implantation with maintained substrate properties. A further object of the present disclosure is to achieve a method for pretreatment of a substrate such that preferential etching is reduced and excessive heating of the substrate is avoided. Yet a further object of the present disclosure is to achieve an effective method for pretreating a surface.

### Summary of the disclosure

According to a first aspect of the present disclosure at least one of these objects is achieved by a method for producing a coated substrate being a cutting tool comprising pre-treating a substrate 200 for surface coating by subjecting the substrate to metal ions and noble gas ions selected from the group of argon-ions, krypton-ions, neon-ions, xenon-ions and helium-ions in a vacuum chamber 10 and applying a negative electrical potential (P1, P2) on the substrate 200, characterized in that the substrate 200 is pre-treated in at least two steps, wherein the steps are performed subsequently in-situ in the vacuum chamber, wherein the first step comprises:
- providing a plasma comprising predominantly noble gas ions selected from the group of argon-ions, krypton-ions, neon-ions, xenon-ions and helium-ions in the vacuum chamber 10, and
- applying a first negative electrical potential (P1) on the substrate 1, and wherein the second step 200 comprises:
- providing a plasma comprising predominantly metal ions in the vacuum chamber 10, the metal ions are metal ions or mixture of metal ions selected from the group 4, 5 or 6 of the periodic table of elements, and
- applying a second negative electrical potential (P2) on the substrate 1, wherein the first electrical potential (P1) is lower than the second electrical potential (P2),
   and wherein the magnitude of the first negative potential (P1) is 100 - 500 V, the magnitude of the second electrical potential (P2) is selected such that metal ions are introduced into the surface of the substrate (200), the magnitude of the second negative potential (P2) is 300 - 3000 V,
   and
- depositing a coating (3000) on the pre-treated substrate.

The method according to the present disclosure provides a cleaned, etched surface with metal implanted in the near-surface region of the substrate thereby obtaining improved adhesion of a subsequently deposited coating. According to the method of the present disclosure, the surface of the substrate is firstly subjected to an etching step with a plasma comprising predominantly noble gas ions selected from the group of argon-ions, krypton-ions, neon-ions, xenon-ions and helium-ions and with a relatively low electrical potential applied on the substrate. The composition of the plasma and the low electrical potential results in that mainly noble gas ions are accelerated towards the substrate at low kinetic energy. Thereby a relatively mild etching effect is achieved and native oxides and impurities are removed without substantial wear of the substrate due to preferential etching of the substrate. The subsequent step of introducing metal ions into the surface is performed with a relatively high electrical potential applied on the surface. However, since the implantation step is separate from the etching step it may be kept short so that heating of the substrate is minimized and negative effects thereof avoided. The inventive method may be performed in-situ in a PVD-apparatus, which makes the method effective and possible to perform at low cost.

Preferably, the method according to the present disclosure is performed in a vacuum chamber 10 comprising an atmosphere comprising a noble gas, or a mixture of noble gases, selected from the group of argon, krypton, neon, xenon and helium; a magnetron 20 operable in HPIMS-mode and a metal target 21, wherein the first step comprises:
- operating the magnetron 20 such that predominantly noble gas ions selected from the group of argon-ions, krypton-ions neon-ions, xenon-ions and helium-ions are present in the plasma, and wherein the second step comprises:
- operating the magnetron 20 such that predominantly metal ions are present in the plasma.

High Power Impulse Magnetron Sputtering (HIPIMS) is preferably used to ionize the atmosphere of noble gas/es selected from the group of argon, krypton, neon, xenon and helium in the vacuum chamber and also to produce metal ions. The characteristics of HIPIMS, i.e. to produce short discharges of very high energy makes it possible to accurately control the type and amounts of ions in the plasma during the different steps of the method according to the disclosure.

In particular it is preferred to operate the magnetron in HIPIMS-mode during the second step of implanting metal ions into the surface of the substrate. This is advantageous since the short discharges of high energy produced by HIPIMS makes it possible to produce sufficient metal ions to be implanted in the surface of the substrate in a very short time interval. This allows for minimizing, or even avoiding, heating of the surface of the substrate.

According to an alternative, the method of the present disclosure is performed in a vacuum chamber 10 comprising an atmosphere comprising a noble gas, or a mixture of noble gases, selected from the group of argon, krypton, neon, xenon and helium; a magnetron 20 operable in HIPIMS-mode; a metal target 21 and a glow-filament 14, wherein the first step comprises:
- operating the glow-filament 14 for a predetermined time period such that plasma is achieved comprising predominantly noble gas ions selected from the group of argon-ions, krypton-ions, neon-ions, xenon-ions and helium-ions and wherein the second step 200 comprises:
   - operating the magnetron 20 such that a plasma comprising predominantly metal ions is achieved.

Ionizing the atmosphere of noble gas/es selected from the group of argon, krypton, neon, xenon and helium by using a glow-filament provides a plasma with very high amount of noble gas ions selected from the group of argon, krypton, neon, xenon and helium. This is so since the glow filament emits electrons that ionize the noble gas in the vacuum chamber. However, the electrons do not have sufficient energy to evaporate metal from the target and the noble gas ions selected from the group of argon, krypton, neon, xenon and helium do not have sufficient mass energy to sputter off metal ions from the target. Therefore, the amount of metal ions in the plasma during the etching step is insignificant.

Using a glow-filament in the first step of the method according to the disclosure results thus in that essentially only noble gas ions selected from the group of argon, krypton, neon, xenon and helium impacts the surface of the substrate during etching. This, in combination with a low electrical potential applied to the substrate, in turn provides a very mild etching of the surface of the substrate with a minimum of preferential etching of sharp features of the substrate.

The present disclosure also relates to a method for producing a coated substrate including the pre-treatment steps disclosed above and a subsequent coating step.

The noble gas ions selected from the group of argon-ions, krypton-ions, neon-ions, xenon-ions and helium-ions, are preferably argon-ions or krypton-ions or a mixture of argon-ions and krypton-ions. Most preferably the noble-gas ions are argon-ions.

The noble gas or mixture of noble gases selected from the group of argon, krypton, neon, xenon and helium, is preferably argon or krypton or a mixture of argon and krypton. Most preferably the noble-gas is argon.

Preferably, the metal ions are chromium ions or titanium ions or a mixture of chromium ions and titanium ions.

Preferably, the metal target comprises or consists of any metal or combination of metals selected from the group 4, 5 or 6 of the periodic table of elements. Preferably the metal target comprises or consists of chromium or titanium or a mixture of chromium and titanium.

### Brief description of the drawings

Figure 1: A schematic drawing of a PVD-apparatus used for performing the method according to the disclosure.
Figure 2: A schematic drawing showing the main steps of the method according to the disclosure.
Figure 3: A diagram showing measurements on samples treated by the method according to the disclosure.
Figure 4: A diagram showing measurements on samples treated by the method according to the disclosure.

### Definitions

By "predominantly noble gas ions selected from the group of argon-ions, krypton-ions, neon-ions, xenon-ions and helium-ions" in the plasma is meant that 50-100 % or 75-100% or 90-100% or 95-100% or 98-100% or 99-100% of the ions in the plasma are constituted by noble gas ions selected from the group of argon-ions, krypton-ions, neon-ions, xenon-ions and helium-ions. By "predominantly metal ions" in the plasma is meant that 50- 100% or 90-100% or 75-100% or 95-100% or 98-100% or 99-100% of the ions in the plasma are constituted by metal ions.

By the expression "an atmosphere comprising a noble-gas, or a mixture of noble-gases, selected from the group of argon, krypton, neon, xenon and helium" is herein meant that the atmosphere may comprise one of argon or krypton or neon or xenon or helium or by any mixture of these two or more of these gases.

By a "mixture of noble gases" is herein meant a mixture of two or more gases selected from the group of argon, krypton, neon, xenon and helium. The gases may be arbitrary selected. Preferably, the mixture of noble gases comprises argon and krypton.

High Power Impulse Magnetron Sputtering (HIPIMS), also known as High Power Pulsed Magnetron Sputtering (HPPMS), is a method for physical vapor deposition of thin films which is based on magnetron sputtering deposition. HIPIMS utilizes high power densities of the order of kW·cm⁻² in short pulses (impulses) of tens of microseconds at low duty cycle (on/off time ratio) of < 10%. Distinguishing features of HIPIMS are a high degree of ionization of the sputtered metal and a high rate of molecular gas dissociation.

When the expression "magnitude of the electrical potential" is used is by "magnitude" meant the absolute value of the electrical potential.

### Detailed description of an embodiment

The method according to the present disclosure will now be described more fully hereinafter.

Same reference numbers refer to same elements throughout the description.

In the detailed description of an embodiment, reference is made to a "noble-gas". By "noble gas" is herein meant at least one gas selected from the group of argon, krypton, neon, xenon and helium. Preferably the "noble gas" is argon or krypton, or a mixture of argon and krypton. The "noble gas" may be krypton. Most preferably the "noble gas" is argon.

In the detailed description of an embodiment, reference is made to "noble gas ions". By "noble gas ions" is herein meant ions selected from the group of argon-ions, krypton-ions, neon-ions, xenon-ions and helium-ions. Preferably the "noble gas ions" are argon-ions or krypton-ions, or a mixture of argon-ions and krypton-ions. Most preferably the "noble gas ions" are argon-ions.

In the detailed description of an embodiment, reference is made to a "metal target". The metal target may comprise or may consist of any metal or combination of metals selected from the group 4, 5 or 6 of the periodic table of elements, for example chromium, titanium or a mixture of chromium and titanium. When in the described embodiment reference is made to a plasma comprising "metal ions" it is appreciated that these "metal ions" originates from the metal target. The "metal ions" are metal ions or a mixture of metal ions selected from the group 4, 5 or 6 of the periodic table of elements, for example chromium, titanium or a mixture of chromium and titanium.

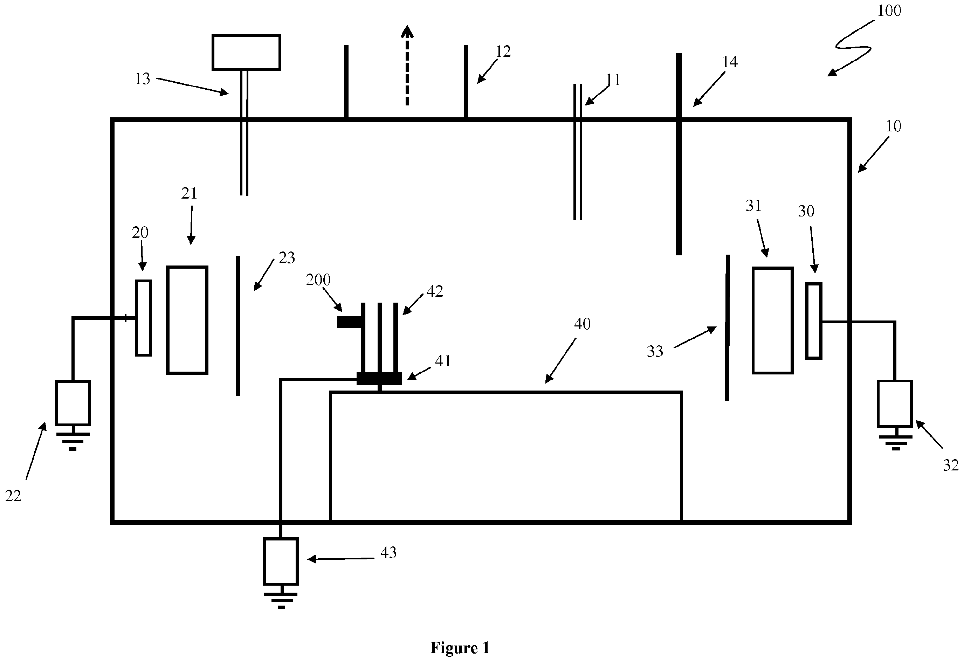

Figure 1 shows a schematic drawing of a PVD-apparatus 100 which may be used for performing the method for pretreating a substrate for surface coating according to the present disclosure. The PVD-apparatus 100 may also be used to coat a substrate which is pre-treated according to the present disclosure.

The PVD apparatus 100 comprises a vacuum chamber 10 having an inlet 11 for introducing the noble gas into the vacuum chamber. The noble gas constitutes the atmosphere in the vacuum chamber 10. An outlet 12 is provided for drawing a vacuum in the vacuum chamber 10, for example by connecting a pump (not shown) to the outlet. A sensor 13, such as an OES-sensor, may be arranged in the vacuum chamber 10 to measure the composition of the atmosphere in the vacuum chamber.

The vacuum chamber 10 further comprises at least one magnetron 20 with a metal target 21. The magnetron 20 is connected to a power supply 22 and arranged to be operated in HIPIMS-mode. The magnetron 20 and the metal target 21 are provided to introduce metal ions into the surface of a substrate in order to improve adhesion to a subsequent coating. The metal target 21 therefore comprises a metal suitable for improving the adhesion of a subsequent coating onto a substrate.

The vacuum chamber 10 may also comprise one or several further magnetrons 30 each connected to a power supply 32 and one or several further metal targets 31. For example a further magnetron with a TiAl alloy target may be provided to apply a subsequent coating on a pre-treated substrate. The further magnetron may be operable in HIPIMS-mode or in other sputtering modes such as DC-sputtering or AC-sputtering or RF-mode. Shutters 23, 33 may be provided in the vacuum chamber 10 to cover, if necessary, the metal targets during certain periods while the magnetrons are operated.

A glow-filament 14 may be provided to produce a plasma comprising noble gas ions for etching a substrate in the first step of the method according to the disclosure. The glow-filament 14 is connected to a power supply (not shown) and when an electrical current is passed through the glow-filament it emits electrons which ionize the noble gas in the vacuum chamber by electron impact ionization into a plasma of noble gas ions.

A dedicated anode (not shown) may be arranged in the vacuum chamber 10 to control the location of the plasma.

The vacuum chamber 10 further comprises at least one substrate 200 to be pre-treated and optionally coated. Typically, the substrate 200 is manufactured of ceramic, cermet, tungsten carbide, high speed steel or combinations thereof. The substrate is a cutting tool comprising an edge portion for machining of work pieces. The substrate is a cutting tool.

The substrate 200 may be supported on a substrate table 40 which is movable in and out of the vacuum chamber 10. The substrate table 40 may comprise one or several satellites 41 on which one or several pins 42, for supporting a substrate 200 are arranged. The pins 42, satellites 41 and substrate table 40 are all rotatable, resulting in a 3-folded rotation of the substrates which makes the pre-treatment process more uniform along the surface exposed towards the source targets.

A further power source 43 is arranged to apply a negative electrical potential of controllable magnitude to the substrates. The power source 43 may thereby be connected to anyone of the substrates 20, the pins 42, the satellites 41 or the table 40.

It is obvious that the PVD-apparatus 100 of figure 1 may comprise several further features, such as doors for accessing the vacuum chamber or control systems for controlling pre-treatment or coating of the substrates.

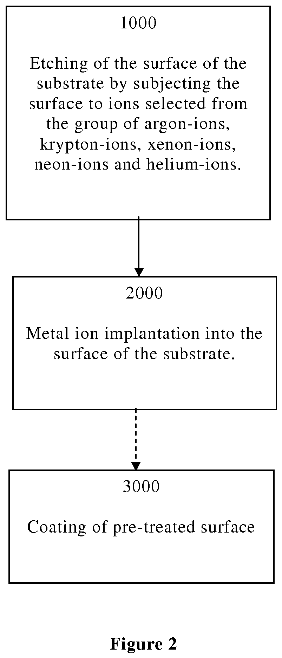

Following the method according to the present disclosure will be described with reference to the PVD apparatus shown in figure 1 and to the main method steps shown in figure 2.

Firstly, one or several substrates 200 are loaded into the vacuum chamber 10 of the PVD-apparatus 100. The substrates are preferably mounted on a substrate table 40. Subsequently the vacuum chamber 10 is sealed and the pressure in the vacuum chamber is reduced by drawing a vacuum through the outlet 12 in the vacuum chamber.

Thereafter a heater system (not shown) is turned on to heat the substrates 200, pins 42, satellites 41 and table 40 to a process temperature of typically 300 - 650°C. The process temperature may be measured by a thermocouple (not shown) connected to the substrate table, or positioned inside the chamber.

When the pressure in the vacuum chamber is below a certain pressure level, typically 10⁻⁴ mbar and the process temperature is reached, the first pre-treatment step 1000 of etching of the substrate may be carried out.

The first pre-treatment step 1000 is performed as follows:
Firstly, noble gas is introduced into the vacuum chamber 10 through the inlet 11 to achieve a process pressure of typically 2 µbar in the vacuum chamber. Thereafter, the first magnetron 20 is operated in HIPIMS-mode such that a plasma comprising noble gas ions and metal ions is achieved. The first magnetron 20 is thereby operated in HIPIMS-modes, with a peak power density PD1 which is selected such that the plasma comprises predominantly noble gas ions.

Peak power density is an important parameter for controlling the ratio between noble gas ions and metal ions in the plasma during HIPIMS. As power is injected from the magnetron into the noble gas atmosphere in the vacuum chamber, the noble gas atmosphere is ionized and heated up which leads to expansion of the ionized noble gas and thus lower density (so called "gas rarefaction" or "sputter wind"). As soon as the ionized gas is rarefied, the flux of noble gas ions to the substrate diminishes and is replaced by metal vapour from the metal target. The degree of ionization of both the noble gas and the metal vapour increases with increasing peak power density, so in order to achieve a plasma which comprises predominantly noble gas ions the peak power density should be low. Correspondingly, to achieve a plasma which comprises predominantly metal ions the peak power density should be high.

Preferably, the amount of noble gas ions should be as high as possible in the plasma. For example, argon ions may constitute 50-100% or 75-100% or 90-100% or 95-100% or 98-100% or 99-100% of the total amount of noble gas ions in the plasma. The amount of noble gas ions and metal ions in the plasma may for example be determined by connecting a mass spectrometer to the vacuum chamber and measure ion charge/mass ratios in the plasma

To ensure an atmosphere of predominantly noble gas ions in the vacuum chamber during the etching step, the peak power density PD1 should be 0.1-0.5 kW/cm², or 0.1-0.3 kW/cm²or 0.15-0.25 kW/cm².

The pulse length during HIPIMS is also important for controlling the amount of noble gas ions and metal ions in the atmosphere since long pulse lengths promote the rarefaction of the noble gas. Long pulse lengths may also, due to inductivity in the cables of the PVD-apparatus, result in high peak currents which increases the density of the plasma and a higher ionization degree of the sputtered metal.

It is therefore preferred that the first pulse length L1 is 2-5000 µs or 10-500 µs or 5-20 µs.

During operation of the magnetron a negative electrical potential P1 is applied by the substrate power source 43 to the substrate 200 in order to accelerate noble gas ions towards the substrate.

When the noble gas is ionized, the atmosphere in the vacuum chamber will predominantly consist of noble gas ions and a plasma sheath, i.e. a zone, which is free of ions will form between the surface of the substrate and the plasma.

The plasma has a slightly positive electrical potential and therefore the negative potential which is applied on the substrate will result in a voltage drop across the plasma sheath, i.e. between the positive plasma and the negative substrate. The voltage drop will result in that the positive noble gas and, if present, metal ions, in the plasma which reach the plasma sheath and be accelerated towards the substrate. The positive ions will bombard the substrate surface and etch it.

It is important to carefully control the magnitude of the negative electrical potential P1. The magnitude of the negative electrical potential P1 needs to be high enough to achieve a sufficiently large voltage drop across the plasma sheath. This is important in order to accelerate positive ions with sufficient kinetic energy towards the substrate to etch its surface. However, at great magnitudes of the negative electrical potentials the voltage drop across the plasma sheath will become too large. This will cause the positively charged noble gas ions and metal ions (if present) to be attracted to sharp features of the substrate, for example an edge, and result in excessive etching there.

Thus, the magnitude of the negative electrical potential need to be low enough to avoid, or reduce, preferential etching of sharp features on the substrate but great enough to achieve sufficient etching of the surface.

A suitable magnitude of the negative electrical potential P1 may be determined by practical tests. For example, by treating a substrate in the vacuum chamber using a first negative electrical potential and analysing the degree of etching of the surface of the substrate for example by using a profilometer or by using a Scanning Electron Microscope (SEM). By performing a series of tests and varying the negative electrical potential towards higher or lower magnitudes between each test it is possible to determine a suitable magnitude of the electrical potential P1.

Sufficient etching of the surface of the substrate is achieved when native oxides and impurities are removed from the surface with no or a minimum of removal of the material of the substrate. After sufficient etching the surface of the substrate is a bare metal surface free of oxides or impurities.

The magnitude of the negative electrical potential P1 can be 150 - 450 V or 200 - 400 V.

In the case when a magnetron operable in HIPIMS mode is used in the first step preferably the magnitude of the negative electrical potential P1 can be 300 - 500 V or 350 - 500 V.

In the case when a glow filament is used in the first step preferably the magnitude of the negative electrical potential P1 can be 150 - 450 V.

The total length (in time) of the etching step depends on external factors such as substrate material and degree and type contamination on the substrate. The total length of the etching step must therefore be determined in view of the conditions prevailing for the etching step in question. This may for example be done by practical tests as described above but with varying total etching time. Typically, the total length of the etching step is 2 - 120 minutes.

For example, the total length of the etching step is 10 - 110 minutes or 20 - 100 minutes or 30 - 90 minutes.

After completion of the etching step, the second pre-treatment step 2000 of introducing metal ions into the surface of substrate is performed.

The magnetron 20 is thereby operated such that predominantly metal ions are present in the plasma. Thereby, the magnetron 20 is operated with a second peak power density PD2 which is higher than the first peak power density PD1 of the etching step. As described above, the higher second peak power density PD2 causes rarefaction of the atmosphere of ionized noble gas ions and results in a plasma which is rich in metal ions.

Preferably, the amount of metal ions should be as high as possible, for example 50-100% or 75-100% or 90-100% or 95-100% or 98-100% or 99-100% of the total amount of ions in the plasma.

Typically rarefaction of the atmosphere and thus creation of a metal ion rich plasma occurs at a peak power density threshold level of approximately 0.5 kW/cm². Therefore the peak power density PD2 should therefore exceed 0.5 kW/cm² in the second pretreatment step. Preferably the peak power density PD2 is 0.5 - 4 kW/cm² or 0.6 - 4 kW/cm² or 1 - 4 kW/ccm² or 1.5 - 3.5 kW/cm².

During the second pre-treatment step, the first pulse length L1 may be changed to a longer second pulse length L2. It is preferred to have a longer pulse length in the second pre-treatment step since the longer pulse length allows for more time for operation in the metal rich plasma and thus increases the net implantation of metal on the substrate. However, at too long pulse lengths the discharge may transit from a glow to an arc which is associated with molten droplets and defects in the microstructure of the deposited metal.

It is therefore preferred that the second pulse length L2 is 30 - 10000 µs or 20 - 1000 µs or 20 - 100 µs or 50 - 75 µs.

During the second pre-treatment step, a negative electrical potential P2 is applied to the substrate by the substrate power source 43.

The magnitude of the electrical potential P2 is greater than the magnitude of the electrical potential P1 of the precedent etching step.

The magnitude of the negative electrical potential P2 must be great enough to achieve a sufficiently large voltage drop across the plasma sheath. This is important in order to accelerate metal ions with sufficiently high kinetic energy to introduce, i.e. implant the metal ions into the surface of substrate. The higher limit of for the magnitude of the negative electrical potential P2 is often set by physical limitations in the production equipment. Also, at high magnitudes of electrical potential the implantation depth of the metal ions may become too high and result in reduced adhesive properties.

A suitable magnitude of the negative electrical potential P2 may be determined by practical tests. For example, by treating a substrate in the vacuum chamber using a first negative electrical potential and determine the presence of chromium in the surface of the substrate, for example by using Scanning Electron Microscopy (SEM) operating in back scatter detector mode or by Electron Diffraction Spectroscopy (EDS). By performing a series of tests and varying the magnitude of the negative electrical potential between each test it is possible to determine a suitable magnitude of the electrical potential P2.

The magnitude of the second electrical potential P2 can be 350 - 2500 V or 400 - 2000 V or 450-1500 V or 500-1200 V.

Preferably, the magnitude of the first electrical potential (P1) and the magnitude of the second electrical potential (P2) are selected such that the ratio P2/P1 is 1.25-5 or 1.25-3 or 1.5-2.

For example, the magnitude of the first electrical potential P1 may be 300 - 500 V and the second electrical potential P2 may be 550 - 1500V. Alternatively, the magnitude of the first electrical potential P1 may be 350 - 450 V and the second electrical potential P2 may be 600 - 1000V.

It is also important to control the total length (in time) of the second pre-treatment step. The second pre-treatment step should be run for a sufficiently long time period to introduce enough metal into the surface of the substrate to achieve improved adhesion of the subsequent coating. However, it is also important to keep the second pretreatment step as short as possible to avoid too much heating substrate which could deteriorate its properties.

The optimal length (in time) of the second pre-treatment step depends on several factors such as the type of material of the substrate and electrical parameters such as effect and current density of the magnetron and may for example be determined by a series of practical tests as described above but with varying total treatment times. Typically, the total length of the second pre-treatment step is 2 - 120 minutes.

Alternatively, the total length of the second pre-treatment step is 2 - 100 minutes or 5 - 80 minutes or 5 - 50 minutes or 10 - 20 minutes.

In an alternative of the pre-treatment method, the plasma in the first step 1000 of etching the substrate is obtained by running a current through a glow-filament 15 present in the vacuum chamber 10. Typically, the glow-filament is operated for 1 -60 minutes, preferably 20 - 40 minutes at filament current of 20 - 50 A.

After completion of the two pre-treatment steps 1000, 2000, the noble gas flow to the vacuum chamber and the electrical power to the first magnetron 20 are turned off. At this stage, the pre-treated substrate may be subjected to an optional coating step 3000 in which a coating, for example a wear resistant coating is applied onto the surface of the pre-treated substrate. However, it is also possible to remove the pre-treated substrate from the vacuum chamber.

The subsequent coating step maybe performed by any suitable deposition method. For example, the coating step could for example consist of one or more of sputter deposition, HIPIMS, arc deposition, e-beam evaporation steps or any combination of these techniques. Coating may be performed in one single coating step or in several coating steps.

The pre-treatment process and the subsequent coating process are preferably performed in a batch process as shown in figure 1. However, the pre-treatment steps 1000, 2000 and the subsequent coating step 3000 could also be carried out in an in-line coating process where the pre-treatment steps 1000, 2000 are carried out in one chamber, and wherein the substrates to be coated subsequently are transferred, without breaking the vacuum or exposing the tools to air atmosphere, to other chambers for the coating step 3000.

### Example

Following the etching step of the method for pre-treating a substrate according to the present disclosure will be described in a concrete experiment.

In the experiment, samples were subjected to etching in a PVD-apparatus and three different negative electrical potentials were applied to the samples during etching. The results of the experiment show that it is possible to achieve minimized preferential etching of the surface of the samples by controlling the magnitude of the electrical potential applied to the sample.

The samples used in the example were square cutting inserts made of tungsten carbide powder and Co binder (WC-Co) type SNMA 12 04 08. The samples had a cutting edge length of 12.7 mm, thickness of 4.7625 mm, corner radius of 0.7938 mm and cutting edge radius of 100 µm. The samples had a fixing hole of diameter 5.156 mm running through the centre of the upper and lower square faces of sample

The upper face of each sample was prepared for etching and subsequent analysis by mechanical grinding and polishing down to a mirror finish with a roughness of Ra < 0.002 µm. The samples were thereafter cleaned in ultrasonic baths containing alkaline and de-ionized water solvents.

Subsequently, the samples were masked using TiO₂ powder-alcohol paste and were left to dry leaving behind a pure TiO₂ line. The mask was ∼ 1 mm wide and was applied perpendicular to the cutting edge at a position half way along the side of the sample. This gave the possibility to measure the etch rate over a distance of just over 3000 µm from the cutting edge.

The samples were divided into three groups and each group was of samples was thereafter subjected to etching in a PVD-apparatus. The samples were mounted in threefold rotation with the square face oriented towards the cathodes in the PVD-apparatus. Argon was used as a process gas. The samples were heated to 400 °C. One cathode of the PVD system was operated in HIPIMS mode at a peak power density of 1 A cm⁻². During etching a constant negative electrical potential (*U*_{BIAS}) was applied to the samples.

A constant negative potential (*U*_{BIAS}) of -200V was applied to the first group of samples during etching.

A constant negative potential (*U*_{BIAS}) of -400V was applied to the second group of samples during etching.

A constant negative potential (*U*_{BIAS}) of -1000V was applied to the third group of samples during etching.

After etching the masking powder and accumulated material were wiped off the samples. The height of the step between the masked and unmasked region was measured using a stylus profilometer (Dektak 150) with a height accuracy of <1 nm and sample positioning accuracy of <50 nm. During the measurements, the cutting edge of the samples was oriented parallel to the scanning direction and measurements were taken with respect to the vertical face and at a distance of every 50-200 µm from the edge. Measurements below 50 µm were not attempted as they fell into the curvature of the cutting edge. The step height represented the thickness of material removed relative to the original surface and was denoted as etching depth. The specific removal rate represents the removal of material per unit time and per unit power and is calculated by dividing the step height by the duration of plasma pretreatment and by the average power on the cathode.

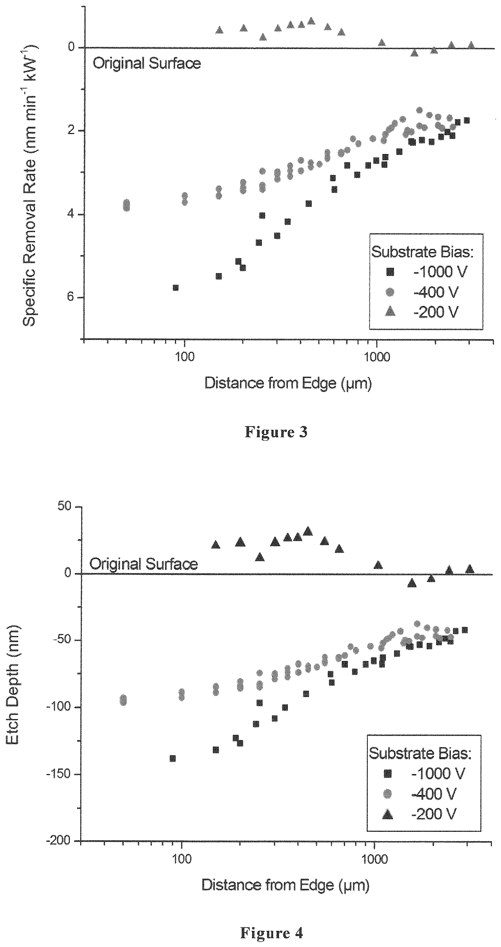

The etching depth is shown in figure 4 and the specific removal rate is shown in figure 3.

The experiments showed that there was a net etching at a substrate bias of *U*_{BIAS} = - 400 V and - 1000 V and there was net deposition at a bias of - 200 V. The sputter yield is almost linearly dependent on substrate bias. In the case of -200 V the deposition of metal vapour occurred at a faster rate than the sputter removal of material by ions.

At *U*_{BIAS} = - 400 V and - 1000 V there was preferential etching near the cutting edge which diminished with distance and reached a constant rate above -1000 µm. The ratio of etching rates at the edge and far away was 50% greater at *U*_{BIAS} = - 1000 V than at *U*_{BIAS} = - 400 V. Thus indicating that less preferential etching occurred at *U*_{BIAS} = - 400 V.

Although a particular embodiment has been disclosed in detail this has been done for the purpose of illustration only, and is not intended to be limiting. In particular it is contemplated that various substitutions, alterations and modifications may be made within the scope of the appended claims.

For example, an arc evaporation source, preferably in combination with a closed shutter, may be used instead of magnetron source 20 or glow-filament 14 to produce the plasma which predominantly comprises noble gas ions in the first step of the pre-treatment method of the present disclosure. Also, for example, a further magnetron source not operating in HIPIMS mode, preferably in combination with a closed shutter, may be used to produce the plasma which predominantly comprises noble gas ions in the first step of the pre-treatment method of the present disclosure. A closed shutter is preferably used in order to prevent deposition of target material during etching.

Although specific terms may be employed herein, they are used in a generic and descriptive sense only and not for purposes of limitation. Furthermore, as used herein, the terms "comprise/comprises" or "include/includes" do not exclude the presence of other elements. Finally, reference signs in the claims are provided merely as a clarifying example and should not be construed as limiting the scope of the claims in any way.

## Claims

1. A method for producing a coated substrate (1), wherein the substrate is a cutting tool, said method comprising:
- pre-treating a substrate (200) for surface coating by subjecting the substrate to metal ions and noble gas ions selected from the group of argon-ions, krypton-ions, neon-ions, xenon-ions and helium-ions in a vacuum chamber (10) and applying a negative electrical potential (P1, P2) on the substrate (200), wherein the substrate (200) is pre-treated in at least two steps (1000, 2000), wherein the steps are performed subsequently in the vacuum chamber (10), wherein the first step (1000) comprises:
- providing a plasma comprising predominantly noble gas ions selected from the group of argon-ions, krypton-ions, neon-ions, xenon-ions and helium-ions in the vacuum chamber (10), and
- applying a first negative electrical potential (P1) on the substrate (200) and wherein the second step (2000) comprises:
- providing a plasma comprising predominantly metal ions in the vacuum chamber (10), the metal ions are metal ions or mixture of metal ions selected from the group 4, 5 or 6 of the periodic table of elements,
and
- applying a second negative electrical potential (P2) on the substrate (200), wherein the first electrical potential (P1) is lower than the second electrical potential (P2),
and wherein the magnitude of the first negative potential (P1) is 100 - 500 V, the magnitude of the second electrical potential (P2) is selected such that metal ions are introduced into the surface of the substrate (200), the magnitude of the second negative potential (P2) is 300 - 3000 V,
and
- depositing a coating (3000) on the pre-treated substrate.

2. The method for producing a coated substrate (1) according to claim 1 wherein the vacuum chamber (10) comprises an atmosphere comprising a noble gas, or a mixture of noble gases, selected from the group of argon, krypton, neon, xenon and helium; and
a magnetron (20) operable in HIPIMS-mode; and
a metal target (21), wherein the first step (1000) comprises:
- operating the magnetron (20) such that predominantly noble gas ions selected from the group of argon-ions, krypton-ions, neon-ions, xenon-ions and helium-ions are present in the plasma, and wherein the second step (2000) comprises:
- operating the magnetron (20) such that predominantly metal ions are present in the plasma.

3. The method for producing a coated substrate (1) according to claim 1 wherein the vacuum chamber (10) comprises an atmosphere comprising a noble gas, or a mixture of noble gases, selected from the group of argon, krypton, neon, xenon and helium; and
a magnetron (20) operable in HIPIMS-mode; and
a metal target (21); and
a glow-filament (14), wherein the first step (1000) comprises:
- operating the glow-filament (14) for a predetermined time period such that a plasma is achieved that predominantly comprises noble gas ions selected from the group of argon-ions, krypton-ions, neon-ions, xenon-ions and helium-ions, and wherein the second step (2000) comprises:
- operating the magnetron (20) such that a plasma predominantly comprising metal ions is achieved.

4. The method according to anyone of the preceding claims, wherein the magnitude of the first electrical potential (P1) is selected such that the surface of the substrate (200) is etched.

5. The method according to claim 2 wherein the magnitude of the first negative potential (P1) is 300 - 500 V.

6. The method according to anyone of the preceding claims wherein the magnitude of the second negative potential (P2) is 300 - 2000 V or 400 - 1000 V.

7. The method according to anyone of claims 2 and 4-5, wherein the first step (1000) comprises:
- operating the magnetron (20) with a first peak power density (PD1) such that predominantly noble gas ions selected from the group of argon-ions, krypton-ions, neon-ions, xenon-ions and helium-ions are present in the plasma.

8. The method according to claim 7, wherein the first peak power density (PD1) is 0.1 - 0.5 kW/cm², or 0.1 - 0.3 kW/cm² or 0.15 - 0.25 kW/cm².

9. The method according to anyone of claims 2-8 wherein the second step (2000) comprises:
- operating the magnetron (20) with a second peak power density (PD2) such that a plasma predominantly comprising metal ions is achieved.

10. The method according to claim 9, wherein the second peak power density (PD2) is 0.5 - 4 kW/cm² or 0.6 -4 kW/cm² or 1 - 4 kW/cm² or 1.5 - 3.5 kW/cm².

## Patentansprüche

1. Verfahren zur Herstellung eines beschichteten Substrats (1) wobei das Substrat ein Schneidwerkzeug ist, wobei das Verfahren umfassend:
- Vorbehandeln eines Substrats (200) für die Oberflächenbeschichtung, indem das Substrat in einer Vakuumkammer (10) Metallionen und Edelgasionen, ausgewählt aus der aus Argon-Ionen, Krypton-Ionen, Neon-Ionen, Xenon-Ionen und Helium-Ionen bestehenden Gruppe, ausgesetzt wird, und Anlegen eines negativen elektrischen Potentials (P1, P2) an das Substrat (200), wobei das Substrat (200) in zumindest zwei Schritten (1000, 2000) vorbehandelt wird, wobei die Schritte anschließend in der Vakuumkammer (10) durchgeführt werden, wobei der erste Schritt (1000) Folgendes umfasst:
- Bereitstellen eines Plasmas, das überwiegend Edelgas-Ionen, ausgewählt aus der aus Argon-Ionen, Krypton-Ionen, Neon-Ionen, Xenon-Ionen und Helium-Ionen bestehenden Gruppe, umfasst, in der Vakuumkammer (10), und
- Anlegen eines ersten negativen elektrischen Potentials (P1) an das Substrat (200), und wobei der zweite Schritt (2000) umfasst:
- Bereitstellen eines Plasmas, das überwiegend Metallionen umfasst, in der Vakuumkammer (10), wobei die Metallionen Metallionen oder eine Mischung von Metallionen sind, die aus der Gruppe 4, 5 oder 6 des Periodensystems der Elemente ausgewählt sind, und
- Anlegen eines zweiten negativen elektrischen Potentials (P2) an das Substrat (200), wobei das erste elektrische Potential (P1) niedriger ist als das zweite elektrische Potential (P2),
und wobei die Größe des ersten negativen Potentials (P1) 100-500 V beträgt, die Größe des zweiten elektrischen Potentials (P2) so gewählt ist, dass Metallionen in die Oberfläche des Substrats (200) eingeführt werden, die Größe des zweiten negativen Potentials (P2) 300-3000 V beträgt,
und
- Aufbringen einer Beschichtung (3000) auf das vorbehandelte Substrat.

2. Verfahren zur Herstellung eines beschichteten Substrats (1) nach Anspruch 1, wobei die Vakuumkammer (10) eine Atmosphäre, umfassend ein Edelgas oder eine Mischung von Edelgasen, ausgewählt aus der aus Argon, Krypton, Neon, Xenon und Helium bestehenden Gruppe, und ein Magnetron (20), das im HIPIMS-Modus betrieben werden kann, und ein Metallziel (21), umfasst, wobei der erste Schritt (1000) umfasst:
- Betreiben des Magnetrons (20), sodass im Plasma vorwiegend Edelgas-Ionen, ausgewählt aus der aus Argon-Ionen, Krypton-Ionen, Neon-Ionen, Xenon-Ionen und Helium-Ionen bestehenden Gruppe, vorhanden sind, und wobei der zweite Schritt (2000) umfasst:
- Betreiben des Magnetrons (20), sodass überwiegend Metallionen im Plasma vorhanden sind.

3. Verfahren zur Herstellung eines beschichteten Substrats (1) nach Anspruch 1, wobei die Vakuumkammer (10) eine Atmosphäre, umfassend ein Edelgas oder eine Mischung von Edelgasen, ausgewählt aus der aus Argon, Krypton, Neon, Xenon und Helium bestehenden Gruppe, und ein Magnetron (20), das im HIPIMS-Modus betrieben werden kann, und ein Metallziel (21), und
einen Glühfaden (14), umfasst, wobei der erste Schritt (1000) umfasst:
- Betreiben des Glühfadens (14) für eine vorbestimmte Zeitdauer, sodass ein Plasma erreicht wird, das überwiegend Edelgasionen, ausgewählt aus der aus Argon-Ionen, Krypton-Ionen, Neon-Ionen, Xenon-Ionen und Helium-Ionen bestehenden Gruppe, umfasst, und wobei der zweite Schritt (2000) umfasst:
- Betreiben des Magnetrons (20), sodass ein Plasma erzielt wird, das überwiegend Metallionen umfasst.

4. Verfahren nach einem der vorhergehenden Ansprüche, wobei die Größe des ersten elektrischen Potentials (P1) so gewählt wird, dass die Oberfläche des Substrats (200) geätzt wird.

5. Verfahren nach Anspruch 2, wobei die Größe des ersten negativen Potentials (P1) 300-500 V beträgt.

6. Verfahren nach einem der vorhergehenden Ansprüche, wobei die Größe des zweiten negativen Potentials (P2) 300-2000 V oder 400-1000 V beträgt.

7. Verfahren nach einem der Ansprüche 2 und 4 bis 5, wobei der erste Schritt (1000) umfasst:
- Betreiben des Magnetrons (20) mit einer ersten Spitzenleistungsdichte (PD1), sodass überwiegend Edelgasionen, ausgewählt aus der aus Argon-Ionen, Krypton-Ionen, Neon-Ionen, Xenon-Ionen und Helium-Ionen bestehenden Gruppe, im Plasma vorhanden sind.

8. Verfahren nach Anspruch 7, wobei die erste Spitzenleistungsdichte (PD1) 0,1-0,5 kW/cm²oder 0,1-0,3 kW/cm² oder 0,15-0,25 kW/cm² beträgt.

9. Verfahren nach einem der Ansprüche 2 bis 8, wobei der zweite Schritt (2000) umfasst:
- Betreiben des Magnetrons (20) mit einer zweiten Spitzenleistungsdichte (PD2), sodass ein Plasma erzielt wird, das überwiegend Metallionen umfasst.

10. Verfahren nach Anspruch 9, wobei die zweite Spitzenleistungsdichte (PD2) 0,5-4 kW/cm² oder 0,6-4 kW/cm² oder 1-4 kW/cm² oder 1,5-3,5 kW/cm² beträgt.

## Revendications

1. Procédé de production d'un substrat revêtu (1) dans lequel le substrat est un outil de coupe, ledit procédé comprenant :
- le prétraitement d'un substrat (200) pour un revêtement de surface en soumettant le substrat à des ions métalliques et des ions de gaz nobles choisis dans le groupe des ions argon, des ions krypton, des ions néon, des ions xénon et des ions hélium dans une chambre à vide (10) et en appliquant un potentiel électrique négatif (P1, P2) au substrat (200), dans lequel le substrat (200) est prétraité en au moins deux étapes (1000, 2000), dans lequel les étapes sont réalisées ultérieurement dans la chambre à vide (10), dans lequel la première étape (1000) comprend :
- la fourniture d'un plasma comprenant principalement des ions de gaz nobles choisis dans le groupe des ions argon, des ions krypton, des ions néon, des ions xénon et des ions hélium dans la chambre à vide (10), et
- l'application d'un premier potentiel électrique négatif (P1) au substrat (200) et dans lequel la deuxième étape (2000) comprend :
- la fourniture d'un plasma comprenant principalement des ions métalliques dans la chambre à vide (10), les ions métalliques sont des ions métalliques ou un mélange d'ions métalliques choisis dans le groupe 4, 5 ou 6 du tableau périodique des éléments, et
- l'application d'un deuxième potentiel électrique négatif (P2) au substrat (200), dans lequel le premier potentiel électrique (P1) est inférieur au deuxième potentiel électrique (P2),
et dans lequel la grandeur du premier potentiel négatif (P1) est de 100 à 500 V, la grandeur du deuxième potentiel électrique (P2) est choisie de telle sorte que des ions métalliques sont introduits dans la surface du substrat (200), la grandeur du deuxième potentiel négatif (P2) est de 300 à 3000 V,
et
- le dépôt d'un revêtement (3000) sur le substrat prétraité.

2. Procédé de production d'un substrat revêtu (1) selon la revendication 1, dans lequel la chambre à vide (10) comprend une atmosphère comprenant un gaz noble, ou un mélange de gaz nobles, choisi dans le groupe de l'argon, du krypton, du néon, du xénon et de l'hélium ; et
un magnétron (20) pouvant fonctionner en mode HIPIMS ; et
une cible métallique (21), dans lequel la première étape (1000) comprend :
- le fonctionnement du magnétron (20) de telle sorte que des ions de gaz principalement nobles choisis dans le groupe des ions argon, des ions krypton, des ions néon, des ions xénon et des ions hélium sont présents dans le plasma, et dans lequel la deuxième étape (2000) comprend :
- le fonctionnement du magnétron (20) de telle sorte que des ions principalement métalliques sont présents dans le plasma.

3. Procédé de production d'un substrat revêtu (1) selon la revendication 1, dans lequel la chambre à vide (10) comprend une atmosphère comprenant un gaz noble, ou un mélange de gaz nobles, choisi dans le groupe de l'argon, du krypton, du néon, du xénon et de l'hélium ; et
un magnétron (20) pouvant fonctionner en mode HIPIMS ; et
une cible métallique (21) ; et
un filament luminescent (14), dans lequel la première étape (1000) comprend :
- le fonctionnement du filament luminescent (14) pendant une période prédéterminée de telle sorte qu'un plasma est obtenu qui comprend principalement des ions de gaz principalement nobles choisis dans le groupe des ions argon, des ions krypton, des ions néon, des ions xénon et des ions hélium, et dans lequel la deuxième étape (2000) comprend :
- le fonctionnement du magnétron (20) de telle sorte qu'un plasma comprenant principalement des ions métalliques est obtenu.

4. Procédé selon l'une quelconque des revendications précédentes, dans lequel la grandeur du premier potentiel électrique (P1) est choisie de telle sorte que la surface du substrat (200) est attaquée.

5. Procédé selon la revendication 2, dans lequel la grandeur du premier potentiel négatif (P1) est de 300 à 500 V.

6. Procédé selon l'une quelconque des revendications précédentes, dans lequel la grandeur du deuxième potentiel négatif (P2) est de 300 à 2000 V ou de 400 à 1000 V.

7. Procédé selon l'une quelconque des revendications 2 et 4 à 5, dans lequel la première étape (1000) comprend :
- le fonctionnement du magnétron (20) avec un première densité de puissance de crête (PD1) de telle sorte que des ions de gaz principalement nobles choisis dans le groupe des ions argon, des ions krypton, des ions néon, des ions xénon et des ions hélium sont présents dans le plasma.

8. Procédé selon la revendication 7, dans lequel la première densité de puissance de crête (PD1) est de 0,1 à 0,5 kW/cm², ou de 0,1 à 0,3 kW/cm² ou de 0,15 à 0,25 kW/cm².

9. Procédé selon l'une quelconque des revendications 2 à 8, dans lequel la deuxième étape (2000) comprend :
- le fonctionnement du magnétron (20) avec une deuxième densité de puissance de crête (PD2) de telle sorte qu'un plasma comprenant principalement des ions métalliques est obtenu.

10. Procédé selon la revendication 9, dans lequel la deuxième densité de puissance de crête (PD2) est de 0,5 à 4 kW/cm² ou de 0,6 à 4 kW/cm² ou de 1 à 4 kW/cm² ou de 1,5 à 3,5 kW/cm².
